# EUROPEAN PATENT APPLICATION

(11) **EP 4 482 027 A1**
(43) Date of publication of application: **25.12.2024**
(21) Application number: 23306005.2
(22) Date of filing: 23.06.2023
(51) Int. Cl.: H03F 1/02, H03F 1/56, H03F 3/195, H03F 3/213, H03F 3/24, H03F 3/60

(54) **DOHERTY AMPLIFIER WITH IMPROVED VIDEO BANDWIDTH**

(71) Applicant: Wolfspeed, Inc., Durham, NC 27703 (US)
(72) Inventor: BOUISSE, Gerard, 31470 Saint-Lys (FR)
(74) Representative: Boult Wade Tennant LLP

(57) **Abstract**

A Doherty amplifier circuit includes a main amplifier section and a peaking amplifier section, an output of the peaking amplifier section being connected to an output of the main amplifier section at a combining node in the Doherty amplifier circuit. The Doherty amplifier circuit further includes a direct current (DC) blocking capacitor connected between the combining node and an output of the Doherty amplifier circuit.

## Description

### FIELD

The present disclosure relates generally to radio frequency (RF) amplifiers, and, more particularly, to Doherty amplifiers having enhanced video bandwidth (VBW) performance.

### BACKGROUND

Electrical circuits requiring high power handling capability while operating at high frequencies, such as, for example, frequencies greater than about 500 MHz, have become increasing more prevalent, particularly in cellular communications applications. There currently is demand for semiconductor devices which are capable of both reliably and efficiently operating at radio and microwave frequencies while still being capable of handling high power loads.

Doherty RF power amplifiers are widely used in communication systems for generating the high power needed for wireless communications. A power amplifier (PA) may include one or more active transistors and passive matching networks at the input and output nodes. Different RF power applications may have differing requirements for power amplifiers, for example, with respect to output power and efficiency. In general, a power amplifier operates at maximum power efficiency when the power amplifier transmits close to saturated power and when an output impedance of the amplifier matches an impedance of a load connected to an output of the amplifier.

Instantaneous bandwidth (IBW) may be an important factor in certain amplifier designs, such as amplifiers for cellular base stations. IBW can be broadly defined as the maximum amount of spectrum a device or amplifier can process while maintaining a generally symmetrical and constant intermodulation product, ensuring that clipping and increased intermodulation distortion do not occur. The instantaneous bandwidth of an amplifier is typically designed to be at least three times as wide as the operational bandwidth of the amplifier in order to suppress intermodulation components. As bit (i.e., data) rates are pushed higher, however, it has become increasingly more challenging to design an RF power amplifier capable of satisfying the correspondingly higher IBW performance criteria.

### SUMMARY

The present invention, as manifested in one or more embodiments, provides a Doherty amplifier having significantly improved IBW performance, compared to standard Doherty amplifier designs. To accomplish this, embodiments of the present inventive concept provide Doherty amplifiers that may include a single output direct current (DC) blocking capacitor that is positioned after a combining node in the Doherty amplifier. This acts to significantly increase the IBW of the Doherty amplifier. Moreover, this novel design also offers the possibility of a simpler (one input) drain biasing for the Doherty amplifier.

In accordance with an embodiment of the present disclosure, a Doherty power amplifier includes a main amplifier section and a peaking amplifier section, an output of the peaking amplifier section being connected to an output of the main amplifier section at a combining node in the Doherty PA circuit. The Doherty amplifier according to one or more embodiments further includes a DC blocking capacitor connected between the combining node and an output of the Doherty amplifier circuit. In some embodiments, at least one of the main amplifier section and the peaking amplifier section includes a metal-oxide semiconductor field-effect transistor (MOSFET) including a drain coupled to the combining node, a source coupled to ground, and a gate adapted to receive an input signal supplied to the Doherty amplifier circuit. The Doherty amplifier may include at least first and second matching inductors connected together between the drain of the MOSFET and a second node, and at least first and second decoupling capacitors. The first decoupling capacitor may be connected between a third node coupling the first and second matching inductors and ground, the first decoupling capacitor being configured to shunt RF signals present at the third node. The second decoupling capacitor may be connected between the second node and ground, the second decoupling capacitor being configured to shunt baseband signals present at the second node.

In accordance with another embodiment, a Doherty amplifier includes a main amplifier circuit and a peaking amplifier circuit, an output of the peaking amplifier circuit being connected to an output of the main amplifier circuit at a combining node in a transmit signal path of the Doherty amplifier circuit. The Doherty amplifier according to one or more embodiments further includes a DC blocking capacitor connected in series in the transmit signal path and shared by the main and peaking amplifier circuits.

In accordance with yet another embodiment, a Doherty amplifier circuit includes a main amplifier stage having an input coupled to an input port of the Doherty amplifier circuit adapted to receive an applied RF signal, and a peaking amplifier stage having an input coupled to the input port of the Doherty amplifier circuit and having an output coupled to an output of the main amplifier stage at a combining node in the Doherty amplifier circuit. The Doherty amplifier circuit further includes a series capacitor connected between the combining node and an output port of the Doherty amplifier circuit. The Doherty amplifier circuit is configured having a video bandwidth (i.e., IBW) characteristic that is agnostic with respect to (i.e., substantially unaffected by) a capacitance value of the series capacitor.

Techniques of the present inventive concept can provide substantial beneficial technical effects. By way of example only and without limitation, techniques according to embodiments of the present disclosure may provide one or more of the following advantages, among other benefits:
output DC blocking capacitor is positioned after the combining node, which may significantly increase the IBW of the Doherty amplifier;
enables the use of a single DC blocking capacitor that may be shared between the main and peaking amplifier stages in the Doherty amplifier, thereby saving cost and circuit complexity;
provides a Doherty amplifier having an IBW that may be agnostic with respect to the capacitance value of the series DC blocking capacitor beyond a minimum value.

These and other features and advantages of the present inventive concept will become apparent from the following detailed description of illustrative embodiments thereof, which is to be read in connection with the accompanying drawings.

### BRIEF DESCRIPTION OF THE DRAWINGS

The accompanying drawings, which are included to provide a further understanding of the invention and are incorporated in and constitute a part of this application, are presented by way of example only and without limitation, wherein like reference numerals (when used) indicate corresponding elements throughout the several views, and wherein:
FIG. 1 is a block diagram depicting at least a portion of an exemplary Doherty power amplifier;
FIG. 2 is a schematic diagram illustrating at least an output portion of an exemplary Class AB (main) section of a Doherty PA;
FIG. 3 is a graph illustrating baseband impedance for the matching network in the exemplary Class AB (main) output section shown in FIG. 2 as a function of frequency;
FIG. 4 is a graph illustrating an influence of the series DC blocking capacitor C_{SER} on baseband impedance as a function of frequency for the matching network in the exemplary Class AB (main) output section shown in FIG. 2;
FIG. 5 is a schematic diagram depicting at least a portion of an exemplary Doherty PA;
FIGS. 6A through 6D are graphs including exemplary waveforms conceptually depicting peaking off state influence of the series DC blocking capacitor C_{SER} in the peaking amplifier section of FIG. 5 prior to combining with the Class AB output section shown in FIG. 2;
FIG. 7 is a schematic diagram illustrating at least a portion of the exemplary Doherty PA shown in FIG. 5, with the series DC blocking capacitor C_{SER} connected between node N4 and the combining node N5 and shown as an equivalent series resistor-inductor-capacitor (RLC) circuit;
FIG. 8 is a schematic diagram depicting at least a portion of an exemplary Doherty PA, according to one or more embodiments of the present invention;
FIGS. 9A and 9B are graphs depicting exemplary waveforms illustrating an influence of a peaking amplifier section for the Doherty PA shown in FIG. 8, according to one or more embodiments of the present invention;
FIG. 10 is a schematic diagram depicting at least a portion of an exemplary Doherty PA, according to one or more embodiments of the present invention; and
FIGS. 11A and 11B are graphs of exemplary waveforms depicting video bandwidth (VBW) performance of the illustrative Doherty PA of FIG. 10, with the DC blocking capacitor placed after the combining node, compared to VBW performance of a Doherty PA with the DC blocking capacitor placed before the combining node (e.g., Doherty PA of FIG. 5), according to one or more embodiments of the present invention.

It is to be appreciated that elements in the figures may be illustrated for simplicity and clarity. Common but well-understood elements that may be useful or necessary in a commercially feasible embodiment are not necessarily shown in order to facilitate a less hindered view of the illustrated embodiments.

### DETAILED DESCRIPTION OF EMBODIMENTS

Principles of the present inventive concept, as manifested in one or more embodiments, may be described herein in the context of an RF power amplifier system, and more specifically to embodiments of a Doherty power amplifier having enhanced performance characteristics, which may be suitable for use in a cellular infrastructure (CIFR) environment, among other beneficial applications. It is to be appreciated, however, that the invention is not limited to the specific devices, circuits, systems and/or methods illustratively shown and described herein. Rather, it will become apparent to those skilled in the art given the teachings herein that numerous modifications to the embodiments shown are contemplated and are within the scope of embodiments of the claimed invention. That is, no limitations with respect to the embodiments shown and described herein are intended or should be inferred.

Pursuant to embodiments of the present invention, Doherty amplifiers are provided that have significantly improved IBW performance. In conventional Doherty amplifiers, the IBW of the amplifier as a whole is much lower than the IBW of its constituent main and peaking amplifiers. In applications having relatively low IBW requirements, this may not raise significant issues, as the IBW of the Doherty amplifier may be sufficient. However, as demand for applications requiring significantly larger IBWs has increased, the inherent limitations in the IBW performance of conventional Doherty amplifiers is a potential problem.

As will be discussed in detail herein, it has been discovered that the design of the DC blocking capacitors included in the main and peaking amplifier stages of conventional Doherty amplifiers may act to significantly limit the IBW of the Doherty amplifier. In conventional Doherty amplifier designs, both the main and peaking amplifiers include their own output DC blocking capacitances, which may be convenient for amplifier tuning purposes, as it allows a designer to test the performance of each individual amplifier separately. Each output DC blocking capacitance is positioned along the respective RF paths before the combining node for the Doherty amplifier. Pursuant to embodiments of the present invention, Doherty amplifiers are provided that may include a single output DC blocking capacitor that is positioned after the combining node. This acts to significantly increase the IBW of the Doherty amplifier (e.g., it may double or triple the IBW in example embodiments). Moreover, this new design also offers the possibility of a simpler (one input) drain biasing for the Doherty amplifier.

A Doherty amplifier circuit according to one or more embodiments includes a main amplifier section and a peaking amplifier section, an output of the peaking amplifier section being connected to an output of the main amplifier section at a combining node in the Doherty PA circuit. The Doherty amplifier according to one or more embodiments further includes a DC blocking capacitor connected between the combining node and an output of the Doherty amplifier circuit. In some embodiments, at least one of the main amplifier section and the peaking amplifier section includes a MOSFET having a drain coupled to the combining node, a source coupled to ground, and a gate adapted to receive an input signal supplied to the Doherty amplifier circuit. The Doherty amplifier may include at least first and second matching inductors connected together between the drain of the MOSFET and a second node, and at least first and second decoupling capacitors. The first decoupling capacitor may be connected between a third node coupling the first and second matching inductors and ground, the first decoupling capacitor being configured to shunt RF signals present at the third node. The second decoupling capacitor may be connected between the second node and ground, the second decoupling capacitor being configured to shunt baseband signals present at the second node.

A Doherty according to one or more embodiments includes a main amplifier circuit and a peaking amplifier circuit, an output of the peaking amplifier circuit being connected to an output of the main amplifier circuit at a combining node in a transmit signal path of the Doherty amplifier circuit. The Doherty amplifier according to one or more embodiments further includes a DC blocking capacitor connected in series in a transmit signal path and shared by the main and peaking amplifier circuits.

A Doherty amplifier circuit according to one or more embodiments includes a main amplifier stage having an input coupled to an input port of the Doherty amplifier circuit adapted to receive an applied RF signal, and a peaking amplifier stage having an input coupled to the input port of the Doherty amplifier circuit and having an output coupled to an output of the main amplifier stage at a combining node in the Doherty amplifier circuit. The Doherty amplifier circuit further includes a series capacitor connected between the combining node and an output port of the Doherty amplifier circuit. The Doherty amplifier circuit is configured having a video bandwidth characteristic that is agnostic with respect to (i.e., substantially unaffected by) a capacitance value of the series capacitor.

RF transistor amplifiers according to embodiments of the present invention may be designed to operate in a wide variety of different frequency bands. In some embodiments, the RF transistor amplifiers may be configured to operate at frequencies greater than 1 GHz. In other embodiments, these RF transistor amplifiers may be configured to operate at frequencies greater than 2.5 GHz. In still other embodiments, the RF transistor amplifiers may be configured to operate at frequencies greater than 3.1 GHz. In yet additional embodiments, these RF transistor amplifiers may be configured to operate at frequencies greater than 5 GHz. In some embodiments, these RF transistor amplifiers may be configured to operate in at least one of the 0.6-1.0 GHz, 1.4-2.7 GHz, 3.4-4.2 GHz, 5.1-5.8 GHz, 12-18 GHz, 18-27 GHz, 27-40 GHz or 40-75 GHz frequency bands or sub-portions thereof.

Video bandwidth (VBW), which may be used synonymously herein with instantaneous bandwidth (IBW) or signal bandwidth (SBW), is a parameter often used to describe the performance of a power amplifier, and generally refers to the maximum modulating frequency that can be used within an RF frequency band. As cellular bit (data) rates are increased, it has become more challenging to design an RF power amplifier capable of satisfying the higher VBW performance criteria. This may be particularly true with respect to Doherty amplifiers.

In cellular communications systems (e.g., CIFR applications), as well as many other radio communication systems where higher power levels and higher efficiency are required (e.g., higher peak-to-average power ratio), a Doherty amplifier architecture is well-suited for use as an RF power amplifier. As is known in the art, a Doherty amplifier circuit includes first and second (or more) power-combined amplifiers. The first amplifier is referred to as a "main" or "carrier" amplifier and the second amplifier is referred to as a "peaking" or "auxiliary" amplifier. The two (or more) amplifiers may be biased differently. For example, the main amplifier may comprise a Class AB or a Class B amplifier while the peaking amplifier may be a Class C amplifier in one common Doherty amplifier implementation. The Doherty amplifier may operate much more efficiently than balanced amplifiers when operating at power levels that are backed off from saturation. An RF signal input to a Doherty amplifier is split (e.g., using a quadrature coupler) into first and second sub-components at a splitting node and the first and second sub-components are passed to the main amplifier and peaking amplifier, respectively. The outputs of the two amplifiers are then combined at a combining node. The main amplifier is configured to turn on first (i.e., at lower input power levels) and hence at lower power levels only the main amplifier will operate. As the input power level is increased towards saturation of the main amplifier, the peaking amplifier turns on and only then is the input RF signal split between the main and peaking amplifiers.

For broadband Doherty architectures, an important objective is to guarantee a proper load modulation for the carrier signal over a broad bandwidth. However, frequency-dependent characteristics can deteriorate this bandwidth. The Doherty amplifier can exhibit broadband behavior at a given power level if the load seen by a quarter-wave transmission line of the amplifier is equal to its characteristic impedance. For a standard Doherty amplifier, this condition only occurs at the peak power. Thus, at peak power, a high impedance can be maintained to provide a high average efficiency over a wide bandwidth. Conventionally, the VBW of a Doherty power amplifier operating at average power has been problematic. As will be described below, embodiments of the present invention provide a beneficial solution to this problem.

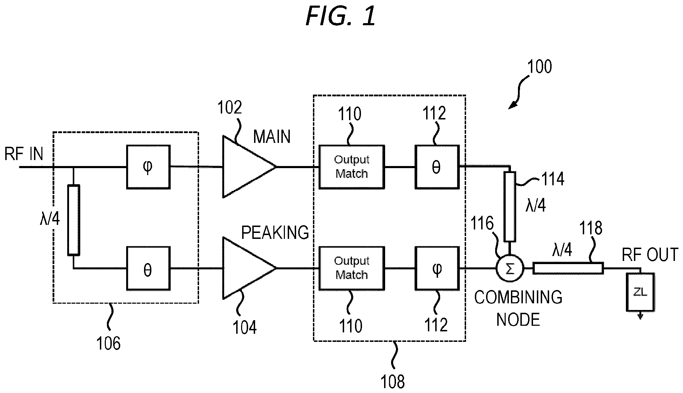

FIG. 1 is a block diagram depicting at least a portion of an exemplary Doherty PA 100. The Doherty PA 100 may include a main (carrier) section (i.e., stage or circuit) or signal path, comprising a main amplifier 102, and a peaking (auxiliary) section or signal path, comprising a peaking amplifier 104. The main amplifier 102 may be implemented as a Class AB amplifier that is always operating. The peaking amplifier 104 may be implemented as a Class C amplifier that only operates (i.e., is in its "on" state) when the Doherty PA 100 is operating close to saturated power levels. The peaking amplifier is typically in its "off' state when the Doherty PA 100 is operating at average power.

Inputs of the main amplifier 102 and peaking amplifier 104 may be connected to an input coupler 106 that is adapted to receive an input RF signal at an input terminal or port (RF IN) of the Doherty PA 100. The input coupler 106 may include circuitry (e.g., 3 dB coupler) configured to split the received input RF signal between the main and peaking sections of the Doherty PA 100. The input coupler 106 may also include circuitry (e.g., phase shifter, delay line, etc.) configured to minimize the adverse effects of phase imbalance between the main and peaking sections of the Doherty PA 100. The input coupler 106 may be configured to route substantially all of the input RF signal to the main amplifier 102 when the peaking amplifier is in its off state.

The Doherty PA 100 may further include a pair of offset lines 108 coupled to respective outputs of the main amplifier 102 and peaking amplifier 104. The offset lines may include impedance matching circuitry 110 that is configured to match the impedance of an output RF signal generated in the main and peaking sections relative to an output load impedance, ZL, connected to an output terminal or port (RF OUT) of the Doherty PA 100. The offset lines may alternatively or additionally include phase shifting circuitry 112 that is configured to appropriately phase the RF signals output by the main and peaking sections.

The output RF signal generated in the main amplifier 102 of the Doherty PA 100 may be passed through a quarter-wave transmission line 114 and provided to a first (input) port of a combining node (i.e., summing node) 116. Likewise, the output RF signal generated in the peaking amplifier 104 of the Doherty PA 100 may be provided to a second (input) port of the combining node 116. A combined output RF signal generated at a third (output) port of the combining node 116 may be passed through a quarter-wave transmission line 118 to the output terminal of the Doherty PA 100.

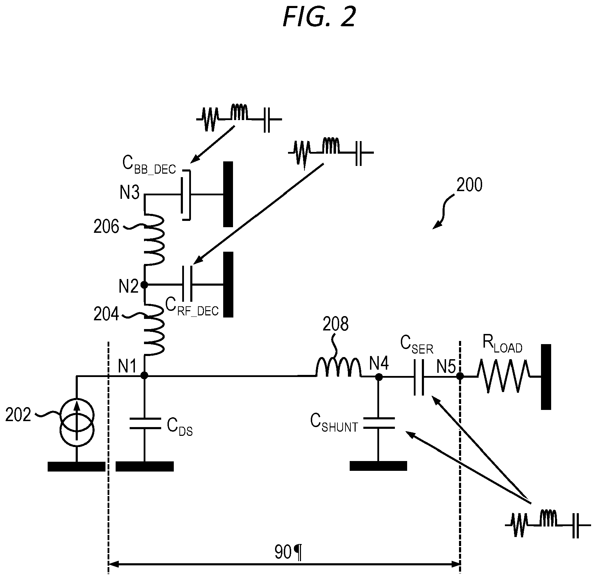

FIG. 2 is a schematic diagram illustrating at least an output portion of an exemplary Class AB (main) section 200 of a Doherty PA. With reference to FIG. 2, the output portion of the Class AB section 200 may include a transistor 202, such as, for example, a power MOSFET device. The transistor 202 may be the amplifying element of the Doherty amplifier. The transistor 202 may be configured (and schematically represented) as a current source. In this embodiment, a drain of the power MOSFET device 202 may be connected to a first node, N1, and a source of the MOSFET device 202 may be connected to ground, or another voltage source. An intrinsic drain-to-source capacitance, C_{DS}, associated with the power MOSFET device 202 is shown connected between node N1 and ground. In some embodiments, the power MOSFET device 202 may be formed of gallium nitride (GaN) and/or silicon carbide (SiC), although embodiments of the invention are not limited to such materials.

It is to be appreciated that, because a metal-oxide semiconductor (MOS) device may be symmetrical by nature, and thus bidirectional, the assignment of source and drain designations in the MOS device is essentially arbitrary. Therefore, the source and drain of the MOS device may be referred to herein generally as first and second source/drain, respectively, where "source/drain" in this context denotes a source or a drain of the MOS device.

The Class AB output section 200 may further include a first matching inductor 204 and a second matching inductor 206 connected together in between the drain of the power MOSFET device 202 at node N1 and a node N3. More particularly, the first matching inductor 204 may include a first terminal connected to node N1 and a second terminal connected to a first terminal of the second matching inductor 206 at a second node, N2. A second terminal of the second matching inductor 206 may be connected to the third node, N3. An RF decoupling capacitor, C_{RF_DEC}, may be connected between node N2 and ground (or a voltage source functioning as an RF virtual ground) and configured to shunt RF signals that may be present at node N2. A baseband decoupling capacitor, C_{BB_DEC}, may be connected between node N3 and ground (or a voltage source functioning as a baseband virtual ground) and configured to shunt baseband signals that may be present at node N3. The values of the RF and baseband decoupling capacitors C_{RF_DEC} and C_{BB_DEC} are preferably selected to shunt signals in the RF and baseband frequency ranges, respectively. In some embodiments, the RF decoupling capacitor C_{RF_DEC} may be about tens of picofarad (pF) and the baseband decoupling capacitor C_{BB_DEC} may be about one to tens of microfarad (µF), although embodiments of the invention are not limited thereto.

The Doherty PA may include a transmission line coupled between the drain of the power MOSFET device 202 of the Class AB output section 200 at node N1 and a combining node of the Doherty PA. In some embodiments, the transmission line may be configured having an impedance matching network comprising a series inductor 208, a series capacitor, C_{SER}, and a shunt capacitor, C_{SHUNT}. Specifically, the series inductor 208 may be connected between node N1 and a fourth node, N4, the series capacitor C_{SER} may be connected between node N4 and a fifth node, N5, and the shunt capacitor C_{SHUNT} may be connected between node N4 and ground (or a voltage source acting as an RF virtual ground). Node N5 may form the combining node of the Doherty amplifier, to which the peaking section (not explicitly shown, but implied) is operatively coupled. The series capacitor C_{SER} provides DC blocking functionality for the Class AB output section 200 of the Doherty PA, and the shunt capacitor C_{SHUNT} in combination with the series inductor 208 provide load impedance matching functionality.

In one or more embodiments, in order to implement a broadband Doherty amplifier, the transmission line may be configured to have an electrical length of about one quarter wavelength, as measured from the drain of the MOSFET device 202 at node N1 to the combining node N5 of the Class AB output section 200, so as to generate a 90-degree phase shift for providing an impedance inversion capability of the main amplifier section; that is, the Class AB output section of the Doherty amplifier is preferably configured to have a length between the main current source 202 and the combining node N5 that corresponds to about 1/4 of a wavelength that corresponds to a center frequency of an operating frequency band of the Doherty amplifier. Although not explicitly shown in FIG. 2, for the peaking amplifier section, an electrical length between a current source (e.g., drain of output MOSFET device in peaking amplifier) and the combining node N5 should be about 180 degrees.

In some embodiments, at least a subset of the components of the Class AB output section 200, for example, the first matching inductor 204, the second matching inductor 206, the decoupling capacitors C_{RF_DEC} and C_{BB_DEC}, the series inductor 208, the series capacitor C_{SER} and the shunt capacitor C_{SHUNT}, may be surface mount devices (SMDs) on a circuit board (e.g., printed circuit board) or other substrate. Each of the SMD capacitors, because of the manner in which they are formed (e.g., multilayer ceramic capacitors (MLCCs)), may be represented as an equivalent series resistor-inductor-capacitor (RLC) network, particularly at RF frequencies. A load impedance, which is shown as a load resistor, R_{LOAD}, is shown coupled between the combining node N5 and ground (or another voltage source). This load impedance corresponds to the impedance of a load connected to the output of the Doherty amplifier 100.

The RF decoupling capacitor C_{RF_DEC} in the Class AB output section 200 may be selected such that at baseband frequencies (e.g., DC to about 300 MHz) and lower RF frequencies (e.g., about 500 MHz to about 2 GHz), the RF decoupling capacitor C_{RF_DEC} is effectively an open circuit, and at higher RF frequencies (e.g., greater than about 3.5 GHz), the RF decoupling capacitor C_{RF_DEC} is effectively a short circuit. This can be achieved, for example, by utilizing a large capacitance value (e.g., tens of µF) and a low equivalent series inductance (ESL). The equivalent series resistance (ESR) of an SMD capacitor may be manifested as a loss but is not frequency-dependent, and therefore will not be discussed further herein. When trying to improve VBW performance of the Doherty PA, by moving passive resonance upwards in frequency, the RF decoupling capacitor C_{RF_DEC} should act as an open circuit. As a consequence, the RF decoupling capacitor C_{RF_DEC} should have a resonance in the higher RF frequency band, but the capacitive component of C_{RF_DEC} should be minimized.

The baseband decoupling capacitor C_{BB_DEC} in the Class AB output section 200 may be selected to have a high capacitance value (e.g., tens of µF) and a low ESL value (e.g., about 1 nanohenry), such that at baseband frequencies (e.g., DC to about 300 MHz) and lower RF frequencies (e.g., about 500 MHz to about 2 GHz), the baseband decoupling capacitor C_{BB_DEC} is effectively a short circuit. At higher RF frequencies (e.g., greater than about 3.5 GHz), the baseband decoupling capacitor C_{BB_DEC}, being large in value, will appear as a short circuit. The baseband decoupling capacitor C_{BB_DEC}, which may be formed as a parallel combination of several capacitor values, may be configured, for example, to have as low an ESL as possible.

The shunt capacitor C_{SHUNT} may be selected to avoid operating close to resonance. At baseband frequencies (e.g., DC to about 300 MHz) and lower RF frequencies (e.g., about 500 MHz to about 2 GHz), the shunt capacitor C_{SHUNT} may be selected so that its attributes have essentially no significant effect on the operation of the Doherty PA. At higher RF frequencies (e.g., greater than about 3.5 GHz), the shunt capacitor C_{SHUNT} may be used as a matching element, in conjunction with the series inductor 208, operating substantially below a passive resonance of the Doherty PA.

The series capacitor C_{SER}, which provides DC blocking functionality for the Class AB output section 200 of the Doherty PA, may be configured to maximize a capacitance value and minimize an ESL value, while having a resonance in the higher RF frequency band. At baseband frequencies (e.g., DC to about 300 MHz), the series capacitor C_{SER} is preferably configured to appear as an open circuit. At lower RF frequencies (e.g., about 500 MHz to about 2 GHz), the series capacitor C_{SER} may be configured having low impedance, and at higher RF frequencies (e.g., greater than about 3.5 GHz), the series capacitor C_{SER} may be configured as a short circuit. To accomplish this, the series capacitor C_{SER} may be configured to have a large capacitance.

When trying to improve VBW performance of the Doherty PA, such as by moving the passive resonance of the Doherty PA upwards in frequency, the series capacitor C_{SER} should function as a short circuit for the resistive load R_{LOAD} to dampen the VBW resonance. As a consequence, the RF decoupling capacitor C_{RF_DEC} should be configured to resonate in the RF frequency band while minimizing the capacitive component of the RF decoupling capacitor C_{RF_DEC} for enhanced VBW performance.

The phase shift created by the impedance matching network in the Class AB output section 200 should be negative 90 degrees for Doherty purposes. This negative transmission phase shift is created by the series inductance; a series capacitance creates a positive transmission phase shift. For Doherty bandwidth purposes, it is appropriate to have the negative transmission phase shift in the series inductance, and minimum positive transmission phase shift in the series capacitance. For a series resonator such as an SMD capacitor, the phase shift is zero at resonance, but the phase slope with frequency varies widely as a function of the capacitive component. As a consequence, a large capacitive component may be required.

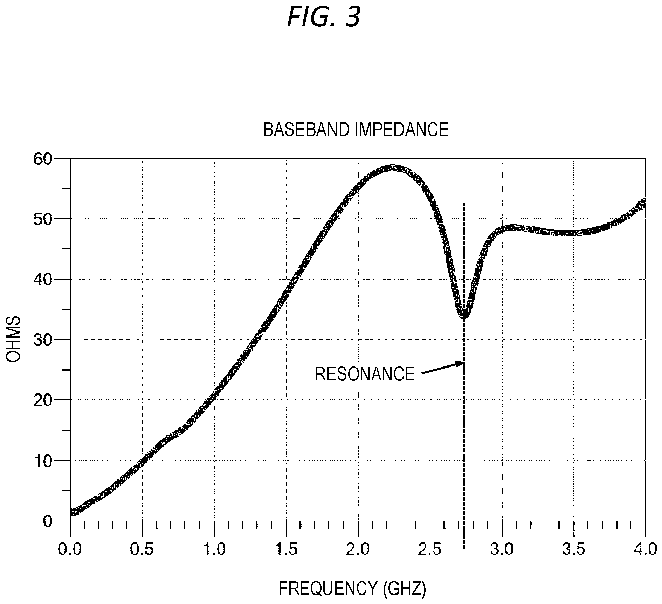

FIG. 3 is a graph illustrating baseband impedance as a function of frequency for the matching network in the exemplary Class AB (main) output section 200 shown in FIG. 2. With reference to FIGS. 2 and 3, the matching network in the Class AB output section 200 exhibits an impedance in about the 3.0 GHz to 4.0 GHz RF frequency range that is closely matched to a 50-ohm resistive load R_{LOAD}. The waveform shown in FIG. 3 may be used as a reference to compare the influence on frequency response characteristics of the Class AB output section 200 by certain inductive and/or capacitive components in the circuit. A resonance region of the Class AB output section 200 may be determined as a function of the baseband decoupling capacitor C_{BB_DEC}, the RF decoupling capacitor C_{RF_DEC}, the first and second matching inductors 204, 206, and the intrinsic drain-to-source capacitance C_{DS} of the power MOSFET in the Class AB output section 200 (represented by the current source 202), which form parallel RLC circuits at node N1. In this example, the resonance region is at about 2.75 GHz.

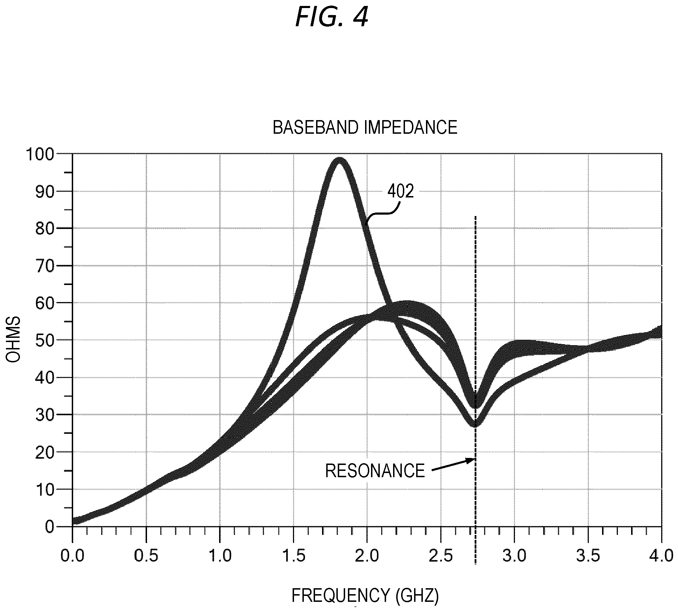

FIG. 4 is a graph illustrating an influence of the series DC blocking capacitor C_{SER} on baseband impedance as a function of frequency for the matching network in the exemplary Class AB (main) output section 200 shown in FIG. 2. For a series DC blocking capacitor C_{SER} having a capacitance of about 1 pF, there is a peaking of impedance of about 100 ohms at a frequency of about 1.8 GHz, as indicated by waveform 402. For low values of capacitance (e.g., about 1 pF or less), the series DC blocking capacitor C_{SER} will appear as an open circuit in the resonance region (e.g., about 2.75 GHz), thereby preventing the load resistance R_{LOAD} from loading the matching network in the Class AB output section 200. As a consequence, the resonance becomes very sharp, which can potentially lead to oscillations. However, as seen in FIG. 4, there is no significant impact on the resonance frequency of the Class AB output section 200.

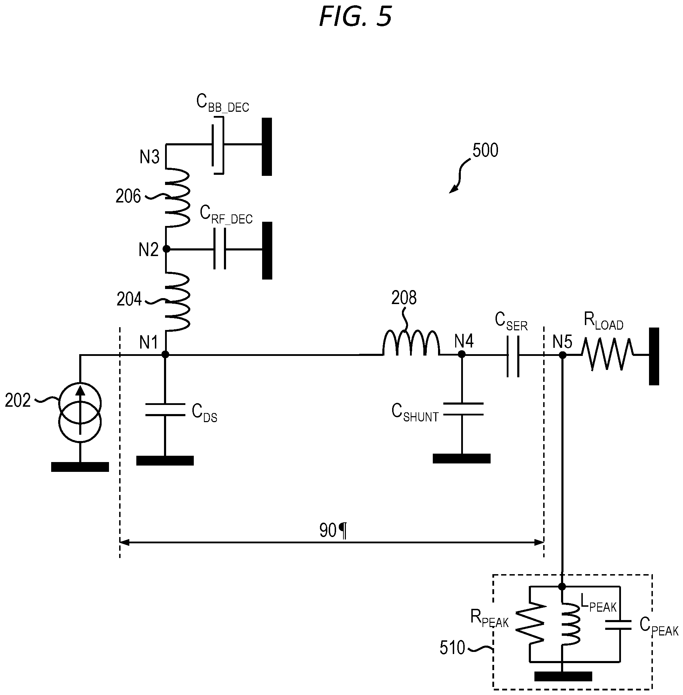

FIG. 5 is a schematic diagram depicting at least a portion of an exemplary Doherty PA 500. The Doherty PA 500 includes a Class AB (main) output section, which may be implemented in a manner consistent with the Class AB output section 200 shown in FIG. 2, and a peaking (auxiliary) amplifier section 510 coupled together at the combining node N5. In this illustration, the peaking amplifier section 510 can be represented as an equivalent parallel RLC network, including a resistor, R_{PEAK}, an inductor, L_{PEAK}, and a capacitor, C_{PEAK}, connected together in parallel between the combining node N5 and ground (or another voltage source). Off-state peaking in the combining node plane may be equivalent to an open circuit. Although not explicitly shown, the peaking amplifier section 510 is preferably coupled to the combining node N5 through a series DC blocking capacitor, in a manner consistent with the series DC blocking capacitor C_{SER} included in the Class AB output section 200.

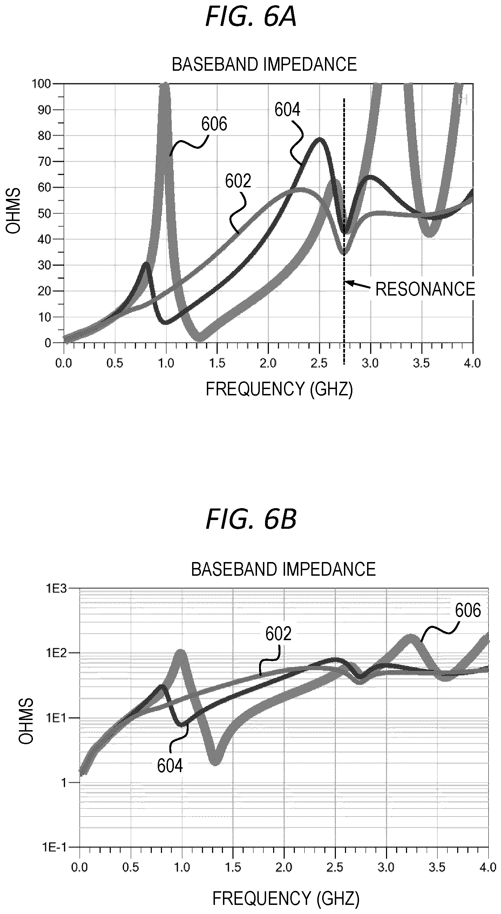

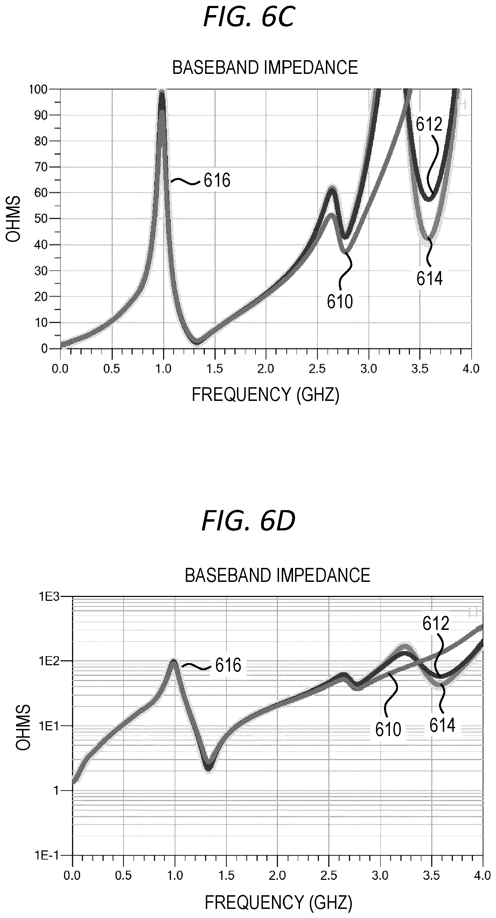

FIGS. 6A through 6D are graphs depicting exemplary waveforms conceptually illustrating the off-state influence of the series DC blocking capacitor C_{SER} in the peaking amplifier section 510 of FIG. 5 prior to combining with the Class AB output section 200 shown in FIG. 2. The graphs illustrate baseband impedance in ohms (y-axis) as a function of frequency in GHz (x-axis). The exemplary waveforms illustrated in FIGS. 6A through 6D may be generated using a series DC blocking capacitance C_{SER} in each amplifier section of about 6.9 pF and resonating at about 3.5 GHz. FIG. 6B is essentially the same as FIG. 6A, except that the baseband impedance (y-axis) in FIG. 6A is represented in a linear scale and is represented in a logarithmic (log) scale in FIG. 6B. Likewise, FIG. 6D is essentially the same as FIG. 6C, except that the baseband impedance (y-axis) in FIG. 6C is represented in a linear scale and is represented in a log scale in FIG. 6D.

In FIGS. 6A and 6B, the capacitive component of the open circuit from the peak amplifier section 510 is varied in a log scale. By way of example only and without limitation, the capacitive component represented by waveform 602 may be 0.1 pF, the capacitive component represented by waveform 604 may be 1.0 pF, and the capacitive component represented by waveform 606 may be 10 pF, although embodiments of the invention are not limited to the specific capacitance values shown. As indicated by waveform 602, an ideal open circuit, which may include a very small capacitance value and a large inductance value, will have no significant effect on the frequency characteristics of the Doherty PA. Alternatively, as will be described in further detail herein below, a realistic (i.e., non-ideal) open circuit representation of the series DC blocking capacitor in the peaking amplifier section may create a much lower resonance (e.g., about 800 MHz rather than about 2 GHz). For example, waveform 604 indicates a resonant peak of about 100 ohms at about 1 GHz using a capacitance of 1.0 pF. Using a capacitance of 10.0 pF, the resonance effectively disappears since it is damped.

In FIGS. 6C and 6D, the resistance of the open circuit presented by the peaking amplifier section is varied to determine the influence of the loss. Waveform 610 represents a resistance of 10 ohms of the open circuit presented by the peaking amplifier section, and waveforms 612, 614 and 616 represent resistances of 100 ohms, 1k ohms and 10k ohms, respectively. As evident from FIGS, 6C and 6D, the waveforms 610, 612, 614, 616 closely converge with one another in a frequency range from DC to about 2.5 GHz, after which the waveforms begin to diverge more significantly. Thus, the resistance of the open circuit presented by the peaking amplifier section only slightly affects a magnitude of the resonance; that is, there is essentially no damping effect.

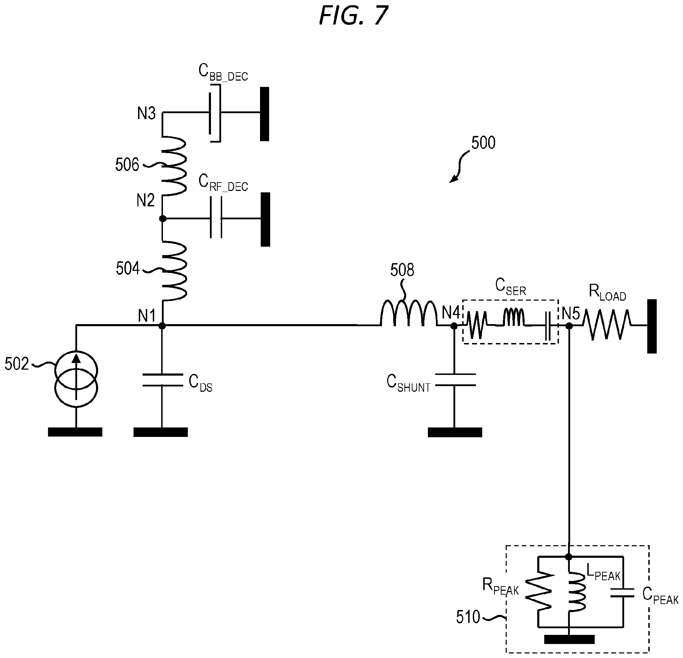

FIG. 7 is a schematic diagram illustrating at least a portion of the exemplary Doherty PA 500 shown in FIG. 5, with the series DC blocking capacitor C_{SER} connected between node N4 and the combining node N5 and shown as an equivalent series RLC circuit. Below resonance, the series capacitor C_{SER} will be a capacitance and the open circuit will be an inductance. The series connection of the elements (i.e., the intrinsic parasitics of the capacitor, ESL and ESR) creates a series resonator that modifies the VBW resonance of the Doherty PA 500 downwards; below the resonance, a series RLC circuit can be viewed as an inductance only, with ESR for loss. From the perspective of a plane of the current source 202 in the main Class AB section of the Doherty PA 500, there will be a parallel resonance, and therefore the capacitance component has a much higher impact on the VBW resonance compared to the inductance component. Thus, it can be demonstrated that in a Doherty PA, the VBW performance is greatly affected by the DC blocking element(s) and its location in the circuit.

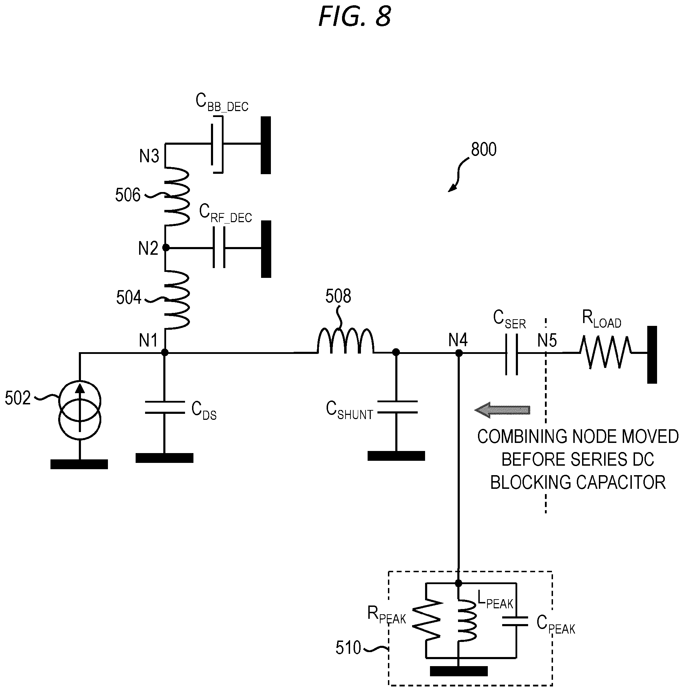

FIG. 8 is a schematic diagram depicting at least a portion of an exemplary Doherty PA 800, according to one or more embodiments of the invention. The Doherty PA 800 is configured similar to the illustrative Doherty PA 500 shown in FIG. 5, except that the combining node has been moved prior to the series DC blocking capacitor C_{SER}; that is, at least for enhanced VBW performance reasons, the DC blocking element in the Doherty PA according to embodiments of the invention should be placed *after* the combining node rather than before the combining node.

More particularly, referring to FIG. 8, the Doherty PA 800 includes a main (carrier) amplifier section, which may be implemented in a manner consistent with the Class AB output section 200 shown in FIG. 2, and a peaking (auxiliary) amplifier section 510, which may be depicted as an equivalent parallel RLC circuit. In this embodiment, the combining node is formed at N4, rather than at node N5, prior to the series DC blocking capacitor C_{SER}. By moving the combining node before the series DC blocking capacitor C_{SER}, the main and peaking amplifier sections in the Doherty PA 800 can share a single series DC blocking capacitor for isolating the resistive load R_{LOAD} from the Doherty PA; that is, each of the main and peaking amplifier sections do not require their own separate series DC blocking capacitors. Furthermore, configuring the Doherty PA 800 in this manner may provide a beneficial improvement in VBW performance of the Doherty PA.

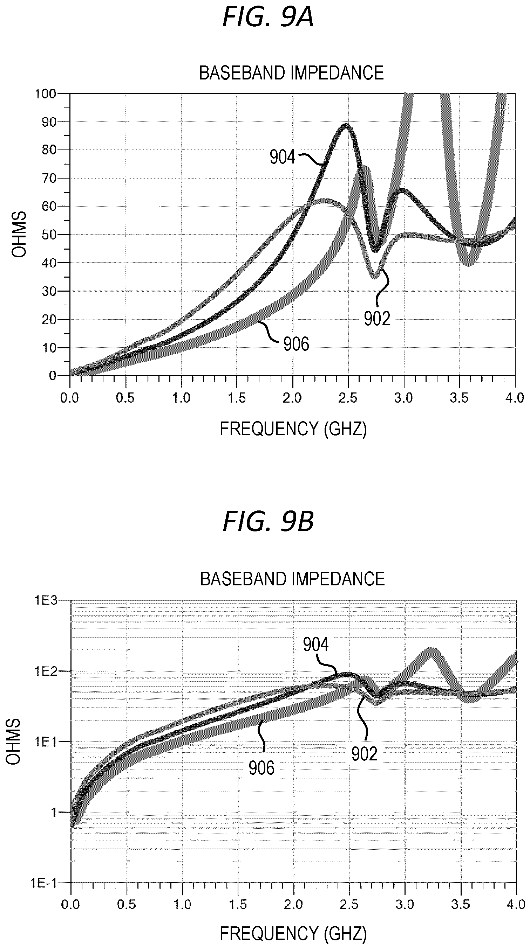

FIGS. 9A and 9B are graphs depicting exemplary waveforms illustrating an influence of the peaking amplifier section for the Doherty PA 800 of FIG. 8, according to one or more embodiments of the invention. The graphs show baseband impedance in ohms (y-axis) as a function of frequency in GHz (x-axis). For the exemplary waveforms illustrated in FIGS. 9A and 9B, it may be assumed that the series DC blocking capacitance C_{SER} is about 6.9 pF and resonates at about 3.5 GHz. FIG. 9B is essentially the same as FIG. 9A, except that the baseband impedance (y-axis) in FIG. 9A is represented in a linear scale and is represented in a log scale in FIG. 9B.

In generating the exemplary waveforms depicted in FIGS. 9A and 9B, the capacitive component of the equivalent parallel RLC circuit representing the peaking amplifier section 510 presented to the combining node N4 (FIG. 8) is varied in a log scale for comparison purposes. Specifically, referring to FIGS. 9A and 9B, waveform 902 may represent a capacitive component C_{PEAK} of the peaking amplifier section 510 of about 0.1 pF, waveform 904 may represent a capacitive component C_{PEAK} of about 1 pF, and waveform 906 may represent a capacitive component C_{PEAK} of about 10 pF. With the Doherty PA 800 of FIG. 8 configured having the combining node N4 before the series DC blocking capacitor C_{SER} according to embodiments of the inventive concept, the series capacitance component does not come into play because it is effectively seen as a resistance (C_{SER} is in series with the load R_{LOAD}, so it is essentially equivalent to a resistance in the frequency range of interest). As a consequence, the VBW resonance is not shifted towards very low frequencies.

In the illustrative Doherty PA 800 according to embodiments of the inventive concept shown in FIG. 8, the combining node N4 is before the series DC blocking capacitor C_{SER}. As such, only the inductive component L_{PEAK} of the open circuit presented by the peaking amplifier section 510 to the combining node N4 may influence the VBW performance of the Doherty PA. For a broadband open circuit presented by the peaking amplifier section 510 to the combining node N4, having a small capacitance component C_{PEAK} and a large inductance component L_{PEAK}, there will be no significant impact on the VBW performance of the Doherty PA 800. For a narrower open circuit presented by the peaking amplifier section 510 to the combining node N4, the inductance component L_{PEAK} may be reduced thereby slightly increasing the VBW resonant frequency of the Doherty PA 800. Thus, with the Doherty PA 800 configured to have the combining node before the series DC blocking capacitor C_{SER}, the capacitance of the series capacitor will have significantly less influence on VBW performance of the Doherty PA.

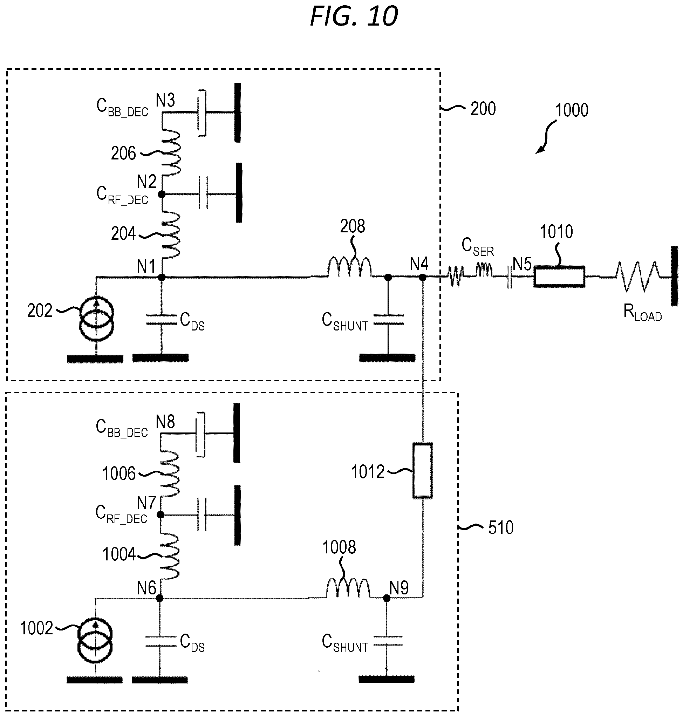

FIG. 10 is a schematic diagram depicting at least a portion of an exemplary Doherty PA 1000, according to one or more embodiments of the invention. The Doherty PA 1000 comprises a main amplifier section 200 and a peaking amplifier section 510. The main amplifier section 200 may be implemented as a Class AB amplifier configured in a manner consistent with the exemplary Class AB output section shown in FIG. 2. The peaking amplifier section 510 may be configured to have an architecture similar to the main amplifier section 200. For example, in some embodiments, the peaking amplifier section 510 may include an output transistor (e.g., a power MOSFET device) 1002, which can be represented as a current source as shown, having a source connected to ground (or another voltage source), and drain connected to a first node, N6. An intrinsic drain-to-source capacitance, C_{DS}, of the MOSFET device 1002 is also shown connected between node N6 and ground.

The peaking amplifier section 510 may further include a first matching inductor 1004 and a second matching inductor 1006 that are connected between the drain of the power MOSFET device 1002 (node N6) and node N8. Specifically, the first matching inductor 1004 may include a first terminal connected to node N6 and a second terminal connected to a first terminal of the second matching inductor 1006 at a second node, N7. A second terminal of the second matching inductor 1006 may be connected to the third node, N8. An RF decoupling capacitor, C_{RF_DEC}, may be connected between node N7 and ground (or a voltage source functioning as an RF virtual ground) and configured to shunt RF signals that may be present at node N7. A baseband decoupling capacitor, C_{BB}__{DEC}, may be connected between node N8 and ground (or a voltage source functioning as a baseband virtual ground) and configured to shunt baseband signals that may be present at node N8. The values of the RF and baseband decoupling capacitors C_{RF_DEC} and C_{BB_DEC} are preferably selected to shunt signals in the RF and baseband frequency ranges, respectively. In some embodiments, the RF decoupling capacitor C_{RF_DEC} may be about tens of picofarad (pF) and the baseband decoupling capacitor C_{BB_DEC} may be about one to tens of microfarad (µP), although embodiments of the invention are not limited thereto.

In some embodiments, the peaking amplifier section 510 may be configured having an impedance matching network comprising a series inductor 1008 and a shunt capacitor, C_{SHUNT}. The series inductor 1008 may be connected between the drain of the MOSFET device 1002 at node N6 and a fourth node, N9. The shunt capacitor C_{SHUNT} may be connected between node N9 and ground (or another voltage source).

The main amplifier section 200 and peaking amplifier section 510 are connected together at the combining node N4. In one or more embodiments, the peaking amplifier section 510 may be coupled to the combining node N4 via a first series transmission line 1012 or another connection means. An electrical length between the drain of the output transistor 202 at node N1 in the main amplifier section 200 and the combining node N4 may be configured to be about 90 degrees; an electrical length between the drain of the output transistor 1002 at node N6 in the peaking amplifier section 510 and the combining node N4 (including the transmission line 1012) may be configured to be about 180 degrees.

As previously described, the combining node N4 is located before the series DC blocking capacitor C_{SER}, which in FIG. 10 is represented by its equivalent series RLC circuit. The series capacitor C_{SER}, which is connected between the combining node N4 and node N5, because of its novel location, provides DC blocking functionality for both the main amplifier section 200 and the peaking amplifier section 510; that is, the main and peaking amplifier sections may beneficially share a single series DC blocking capacitor C_{SER}.

In some embodiments, at least a subset of the components of the main amplifier section 200 and peaking amplifier section 510, for example, the first and second matching inductors 204, 206 in the main amplifier section, the first and second matching inductors 1004, 1006 in the peaking amplifier section, as well as the RF and baseband decoupling capacitors C_{RF_DEC}, C_{BB_DEC}, and shunt capacitors C_{SHUNT} in the main and peaking amplifier sections, may be implemented using SMDs on a circuit board or other substrate. As previously explained, each of the SMD capacitors, because of the manner in which they may be formed (e.g., MLCCs), can be represented as an equivalent series RLC network, particularly at RF frequencies.

The load impedance, which is schematically represented as a load resistor R_{LOAD}, is shown coupled to the series DC blocking capacitor C_{SER} at node N5 through a second series transmission line 1010 or another connection means.

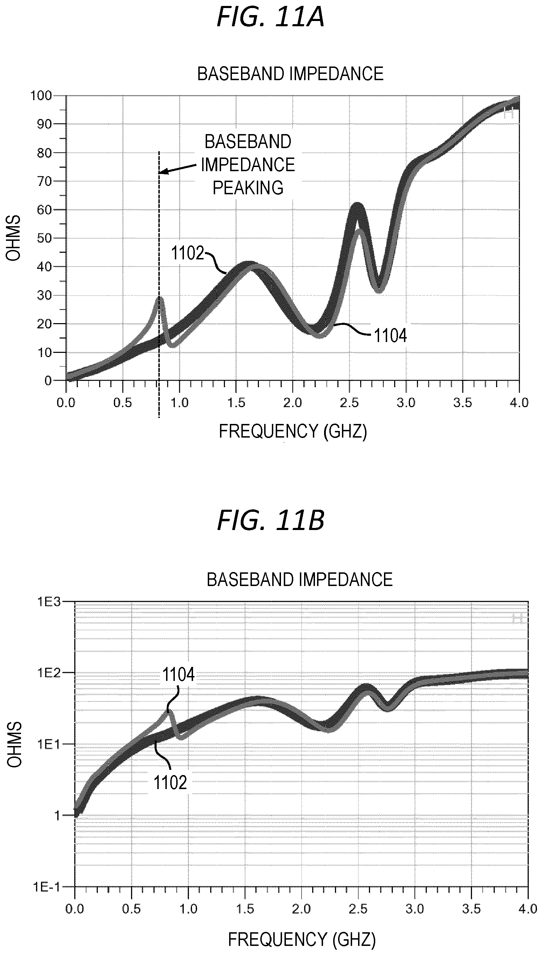

FIGS. 11A and 11B are graphs of exemplary waveforms depicting VBW performance of the illustrative Doherty PA 1000 of FIG. 10, with the DC blocking capacitor placed after the combining node, compared to VBW performance of a Doherty PA with the DC blocking capacitor placed before the combining node (e.g., Doherty PA 500 of FIG. 5), according to one or more embodiments of the invention. FIG. 11B is essentially the same as FIG. 11A, except that the baseband impedance (y-axis) in FIG. 11A is represented in a linear scale and the baseband impedance in FIG. 11B is represented in a log scale. Waveform 1102, which represents the baseband impedance presented at the combining node of the Doherty PA 1000 of FIG. 10 in accordance with embodiments of the invention, is compared to waveform 1104, which represents the baseband impedance presented at the combining node of a standard Doherty PA (e.g., the Doherty PA 500 shown in FIG. 5) wherein the series DC blocking capacitor is connected before the combining node.

With reference to FIGS. 11A and 11B, waveform 1104, representing the Doherty PA with the series blocking capacitor placed before the combining node, exhibits a resonance around 830 MHz. By comparison, waveform 1102 exhibits a suppressed baseband resonance which comes from the full Doherty PA. This smoothing of the baseband impedance has a beneficial result of improving VBW performance of the Doherty PA.

Embodiments of the present disclosure may be used in various cellular infrastructure (CIFR) RF power products (including, but not limited to 5W, 10W, 20W, 40W, 60W, 80W and different frequency bands) e.g., for 5G and base station applications, as well as for radar and monolithic microwave integrated circuit (MMIC)-type applications. More generally, any RF PA may be used in conjunction with and may benefit from embodiments of the present disclosure.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

The terminology used herein is for the purpose of describing particular embodiments only and is not intended to be limiting of the invention. As used herein, the singular forms "a," "an" and "the" are intended to include the plural forms as well, unless the context clearly indicates otherwise. It will be further understood that the terms "comprises," "comprising," "includes" and/or "including," as may be used herein, are intended to specify the presence of stated features, integers, steps, operations, elements, and/or components, but do not necessarily preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this invention belongs. It will be further understood that terms used herein should be interpreted as having a meaning that is consistent with their meaning in the context of this specification and the relevant art and will not be interpreted in an idealized or overly formal sense unless expressly so defined herein.

It will be understood that when an element such as a layer, region, or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below," "above," "upper," "lower," "horizontal," "lateral," and/or "vertical," may be used herein to describe a relationship of one element, layer or region to another element, layer or region as illustrated in the figures. It will be understood, however, that these terms are intended to encompass different orientations of the device in place of or in addition to the orientation depicted in the figures.

Like numbers refer to like elements throughout the several drawings. Thus, the same or similar numbers may be described with reference to other drawings even if they are neither mentioned nor described in the corresponding drawing. Also, elements that are not denoted by reference numbers may be described with reference to other drawings.

In the drawings and specification, there have been disclosed typical embodiments of the invention and, although specific terms are employed, they are used in a generic and descriptive sense only and not for purposes of limitation, the scope of the invention being set forth in the following claims.

## Claims

1. A Doherty amplifier circuit, comprising:
a main amplifier section;
a peaking amplifier section, an output of the peaking amplifier section connected to an output of the main amplifier section at a combining node in the Doherty amplifier circuit; and
a direct current (DC) blocking capacitor connected between the combining node and an output of the Doherty amplifier circuit.

2. The Doherty amplifier circuit according to claim 1, wherein at least one of the main amplifier section and the peaking amplifier section comprises:
a metal-oxide semiconductor field-effect transistor (MOSFET) including a first source/drain coupled to the combining node, a second source/drain coupled to ground, and a gate adapted to receive an input signal supplied to the Doherty amplifier circuit;
first and second matching inductors connected together between the first source/drain of the MOSFET and a second node;
a first decoupling capacitor connected between a third node coupling the first and second matching inductors and ground, the first decoupling capacitor configured to shunt radio frequency (RF) signals present at the third node;
a second decoupling capacitor connected between the second node and ground, the second decoupling capacitor configured to shunt baseband signals present at the second node.

3. The Doherty amplifier circuit according to claim 2, wherein each of at least a subset of the first and second decoupling capacitors and the DC blocking capacitor comprises a multilayer ceramic capacitor (MLCC).

4. The Doherty amplifier circuit according to any of claims 1 to 3, further comprising an impedance matching network connected between the output of the main amplifier section and the combining node.

5. The Doherty amplifier circuit according to claim 4, wherein the impedance matching network comprises:
an inductor connected between the output of the main amplifier section and the combining node; and
a shunt capacitor connected between the combining node and ground.

6. The Doherty amplifier circuit according to any of claims 1 to 5, further comprising an impedance matching network connected between the output of the peaking amplifier section and the combining node.

7. The Doherty amplifier circuit according to claim 6, wherein the impedance matching network comprises:
an inductor connected between the output of the peaking amplifier section and the combining node; and
a shunt capacitor connected between the combining node and ground.

8. The Doherty amplifier circuit according to any of claims 1 to 7, wherein one or both of:
the main amplifier section comprises: a metal-oxide semiconductor field-effect transistor (MOSFET) including a first source/drain coupled to the combining node, and a second source/drain coupled to ground; and a transmission line coupled between the first source/drain of the MOSFET and the combining node, the transmission line configured to have an electrical length of about 90 degrees, as measured from the first source/drain of the MOSFET to the combining node; and
the peaking amplifier section comprises: a metal-oxide semiconductor field-effect transistor (MOSFET) including a first source/drain coupled to the combining node, and a second source/drain coupled to ground; and a transmission line coupled between the first source/drain of the MOSFET and the combining node, the transmission line configured to have an electrical length of about 180 degrees, as measured from the first source/drain of the MOSFET to the combining node.

9. A Doherty amplifier circuit, comprising:
a main amplifier circuit;
a peaking amplifier circuit, an output of the peaking amplifier circuit connected to an output of the main amplifier circuit at a combining node in a transmit signal path of the Doherty amplifier circuit; and
a DC blocking capacitor connected in series in the transmit signal path and shared by the main and peaking amplifier circuits.

10. The Doherty amplifier circuit according to claim 9, wherein at least one of the main and peaking amplifier circuits comprises:
a metal-oxide semiconductor field-effect transistor (MOSFET) including a first source/drain coupled to the combining node, a second source/drain coupled to ground, and a gate adapted to receive an input signal supplied to the Doherty amplifier circuit;
first and second matching inductors connected together between the first source/drain of the MOSFET and a second node;
a first decoupling capacitor connected between a third node coupling the first and second matching inductors and ground, the first decoupling capacitor configured to shunt radio frequency (RF) signals present at the third node;
a second decoupling capacitor connected between the second node and ground, the second decoupling capacitor configured to shunt baseband signals present at the second node.

11. The Doherty amplifier circuit according to claim 9 or claim 10, wherein the main amplifier circuit comprises:
a metal-oxide semiconductor field-effect transistor (MOSFET) including a first source/drain coupled to the combining node, and a second source/drain coupled to ground; and
a transmission line coupled between the first source/drain of the MOSFET and the combining node, the transmission line configured to have an electrical length of about 90 degrees, as measured from the first source/drain of the MOSFET to the combining node.

12. The Doherty amplifier circuit according to any one of claims 9 to 11, wherein one or more of:
the peaking amplifier circuit comprises: a metal-oxide semiconductor field-effect transistor (MOSFET) including a first source/drain coupled to the combining node, and a second source/drain coupled to ground; and a transmission line coupled between the first source/drain of the MOSFET and the combining node, the transmission line configured to have an electrical length of about 180 degrees, as measured from the first source/drain of the MOSFET to the combining node;
the Doherty amplifier circuit further comprises an impedance matching network connected between the output of the main amplifier circuit and the combining node; and
the DC blocking capacitor is configured to maximize a capacitance value and minimize an equivalent series inductance value, and to have a resonance in a higher RF frequency band.

13. A Doherty amplifier circuit, comprising:
a main amplifier stage having an input coupled to an input port of the Doherty amplifier circuit adapted to receive an applied radio frequency (RF) signal;
a peaking amplifier stage having an input coupled to the input port of the Doherty amplifier circuit and having an output coupled to an output of the main amplifier stage at a combining node in the Doherty amplifier circuit; and
a series capacitor connected between the combining node and an output port of the Doherty amplifier circuit,
wherein the Doherty amplifier circuit is configured having a video bandwidth characteristic that is agnostic with respect to a capacitance value of the series capacitor.

14. The Doherty amplifier circuit according to claim 13, wherein:
the Doherty amplifier circuit further comprises an impedance matching network connected between the output of the main amplifier stage and the combining node; and/or
the series capacitor is configured to maximize a capacitance value thereof, to minimize an equivalent series inductance value, and to have a resonance at a frequency of greater than about 3.5 GHz.

15. The Doherty amplifier circuit according to claim 13 or claim 14, wherein one or both of:
the main amplifier stage comprises: a metal-oxide semiconductor field-effect transistor (MOSFET) including a first source/drain coupled to the combining node, and a second source/drain coupled to ground; and a transmission line coupled between the first source/drain of the MOSFET and the combining node, the transmission line configured to have an electrical length of about 90 degrees, as measured from the first source/drain of the MOSFET to the combining node; and
the peaking amplifier stage comprises: a metal-oxide semiconductor field-effect transistor (MOSFET) including a first source/drain coupled to the combining node, and a second source/drain coupled to ground; and a transmission line coupled between the first source/drain of the MOSFET and the combining node, the transmission line configured to have an electrical length of about 180 degrees, as measured from the first source/drain of the MOSFET to the combining node.
